# EUROPEAN PATENT SPECIFICATION

(11) **EP 3 993 590 B1**
(45) Date of publication and mention of the grant of the patent: **24.07.2024**
(21) Application number: 21203026.6
(22) Date of filing: 15.10.2021
(51) Int. Cl.: H05K 9/00, H05K 5/00, H05K 7/14

(54) **ELECTRONIC DEVICE FOR A VEHICLE**
ELEKTRONISCHE VORRICHTUNG FÜR EIN FAHRZEUG
ÉQUIPEMENT ÉLECTRONIQUE POUR VÉHICULE

(30) Priority: 30.10.2020 GB 202017238
(43) Date of publication of application: 04.05.2022
(73) Proprietor: Aptiv Technologies AG, 8200 Schaffhausen (CH)
(72) Inventor: MELFRIED, Sebastian, 30-838 Kraków (PL); BARSZCZOWSKI, Maciej, 43-300 Bielsko Biala (PL)
(74) Representative: Lewis Silkin LLP

(56) References cited:
- US-A1- 2003 230 616
- US-B1- 6 186 800

## Description

The present disclosure relates to the field of the electronic devices, and in particular in the field of the electronic devices including several parts such as one or several electronic substrate(s) (typically printed circuit boards), supporting frames, cover parts which need to be assembled before integration into a vehicle. Such an electronic device can be for example a camera (in the visible field, or in the infra red field) used for example in a vehicle.

### BACKGROUND

Typically, the internal components of an electronic device can be screwed together, but this requires high precision tooling (small dimensions, small torques...), for implementing time consuming assembly steps.

It is also known to provide elastic or snap fit couplings, as disclosed in documents DE102014212762 A1 or US5353201A. However, the solution disclosed in these documents may not be suitable to provide reliable coupling for thin, flexible, low resistance or fragile parts, such as electronic substrate(s) (typically printed circuit boards, with a rigid frame or with flexible film substrate). Document US2003230616A1 discloses a sheet and an electronic apparatus using the sheet. Document US6186800B1 discloses a circuit board grounding and support structure.

The present disclosure improves the situation with the above-mentioned drawbacks. In particular, a purpose of the present disclosure is to provide an electronic device having components designed to achieve a fast, reliable and low-cost assembly.

### SUMMARY

The invention is as set out in the independent claims, further aspects of the invention are outlined in the dependent claims. The present disclosure relates to an electronic device such as a camera for a vehicle, including:
- a supporting frame,
- a main electronic substrate, provided with at least one electric or electronic component or circuit and coupled to the supporting frame;
- wherein the supporting frame has at least one main projecting tab, capable to occupy a non-twisted position or a twisted position,
and wherein the main projecting tab, when in the twisted position, attaches the main electronic substrate to the supporting frame, the electronic device includes a main cover part, and wherein said at least one of the main projecting tab:
- when in the non-twisted position, is interfering with the main cover part, so as to prevent an assembly operation of the main cover part to the electronic device ;
- when in the twisted position, is not interfering with the main cover part, so as to allow an assembly operation of the main cover part to the electronic device.

The electronic device according to the above embodiment includes a supporting frame with projecting tabs which can be bent to provide the attachment of the electronic substrates. Therefore, the assembly does not require any screw, thus simplifying the manufacturing. In addition, the projecting tab, when in the non-twisted position, provides a visual indication that the attachment is not finished.

The main projecting tabs according to the above embodiment are used as mistake-proofing or poka-yoke. Indeed, if one of the main projecting tabs is/are not bent or twisted, the further assembly of the main cover part is not possible.

According to an embodiment, the electronic device includes:
- a secondary electronic substrate, provided with at least one electric or electronic component or circuit and coupled to the supporting frame;
- wherein the supporting frame has at least one secondary projecting tab, capable to occupy a non-twisted position or a twisted position,
and wherein the secondary projecting tab, when in the twisted position, attaches the secondary electronic substrate to the supporting frame.

According to an embodiment:
the main electronic substrate is defining a first plane;
the secondary electronic substrate is defining a second plane;
and the second plane is distinct from the first plane, preferably the second plane and the first plane are intersecting planes, and preferably the second plane and the first plane are perpendicular planes.

Complex shapes can be provided with the above embodiment (perpendicular electronic substrates), but the assembly is less complicated compared to the case of the prior art where the attachment is provided by screws with several different directions of screwing. In the present case, the attachment is easily provided by bending the main and secondary projecting tabs.

According to an embodiment, the main cover part is coupled to the supporting frame, preferably in a sliding arrangement.

According to an embodiment the electronic device includes at least one elastic leg, wherein the main cover part is locked to the supporting frame in a final position by the elastic leg.

According to an embodiment the electronic device includes a secondary cover part, and at least one of the main projecting tab and the secondary projecting tab:
- when in the non-twisted position, is interfering with the secondary cover part, so as to prevent an assembly operation of the secondary cover part to the electronic device ;
- when in the twisted position, is not interfering with the secondary cover part, so as to allow an assembly operation of the secondary cover part to the electronic device,
or wherein said at least one of the secondary projecting tab:
- when in the non-twisted position, is interfering with the main cover part, so as to prevent an assembly operation of the main cover part to the electronic device ;
- when in the twisted position, is not interfering with the main cover part, so as to allow an assembly operation of the main cover part to the electronic device.

The main and/or secondary projecting tabs according to the above embodiment are used as mistake-proofing or poka-yoke. Indeed, if one of the main and/or secondary projecting tabs is/are not bent or twisted, the further assembly of the secondary cover part is not possible, or the secondary projecting tabs according to the above embodiment can be used as mistake-proofing or poka-yoke for the main cover part.

According to an embodiment the secondary cover part includes a decorative cover part and a window preferably made of an infra red transparent material.

According to an embodiment the electronic device includes a conductive paste strand at least in contact with the main electronic substrate and/or the secondary electronic substrate. Such conductive paste strand is providing effective electro-magnetic radiation protection.

According to an embodiment, the main electronic substrate has a main through hole and/or the secondary electronic substrate has a secondary through hole,
the main projecting tab is passing through the main through hole and/or the secondary projecting tab is passing through the secondary through hole,
and the conductive paste strand has a portion surrounding the main through hole and/or the secondary through hole. The contact of the conductive paste strand is ensured/enhanced around the through hole by the bending of the projecting tab onto the electronic substrate, even if the latter presents a high flexibility.

According to an embodiment, the main projecting tab or the secondary projecting tab presents a twisted length over the main electronic substrate, and the conductive paste strand has a portion located from the main through hole and/or the secondary through hole at a distance less than the twisted length.

According to an embodiment, the conductive paste strand has a portion located from the main through hole and/or the secondary through hole by less than 20 mm.

According to an embodiment, the conductive paste strand has a portion surrounding the main electronic substrate and/or the secondary electronic substrate.

According to an embodiment, the supporting frame is a metallic part.

According to an embodiment:
the attachment of the main electronic substrate to the supporting frame is solely or exclusively provided by the main projecting tab in the twisted position,
the attachment of the secondary electronic substrate to the supporting frame is solely or exclusively provided by the secondary projecting tab in the twisted position

In other words, the disclosure relates to an electronic device such as a camera for a vehicle, including:
- a main electronic substrate, provided with at least one electric or electronic component or circuit;
- a supporting frame, coupled to the main electronic substrate,
- a main cover part, covering at least partially the main electronic substrate, characterized in that:
- the supporting frame has at least one main projecting tab capable to occupy a non-twisted position or a twisted position,

wherein the main projecting tab, when in the twisted position, is providing an attachment of the main electronic substrate to the supporting frame,
and wherein the main projecting tab, when in the non-twisted position, is interfering with the main cover part so as to prevent an assembly operation of the main cover part to the electronic device.

According to an embodiment, the electronic device includes a secondary electronic substrate provided with at least one electric or electronic component or circuit;
wherein the supporting frame has at least one secondary projecting tab capable to occupy a non-twisted position or a twisted position,
wherein the secondary projecting tab, when in the twisted position, is providing an attachment of the secondary electronic substrate to the supporting frame,

According to an embodiment, the secondary projecting tab, when in the non-twisted position, is interfering with the main cover part so as to prevent the assembly of the main cover part to the electronic device.

According to an embodiment, the electronic device includes a secondary cover part covering at least partially the secondary electronic substrate, wherein the secondary projecting tab, when in the non-twisted position, is interfering with the secondary cover part so as to prevent an assembly of the secondary cover part to the electronic device.

A third aspect of the disclosure relates to a vehicle, including an electronic device according to the first or second aspect of the disclosure.

### BRIEF DESCRIPTION OF THE DRAWINGS

Other features, purposes and advantages of the disclosure will become more explicit by means of reading the detailed statement of the nonrestrictive embodiments made with reference to the accompanying drawings.

### DETAILED DESCRIPTION

Figure 1 shows an exploded view of an electronic device according to an embodiment of the disclosure,
Figure 2 shows a supporting frame and a main electronic substrate of the electronic device of figure 1, during a step of assembly,
Figure 3 shows the supporting frame and the main electronic substrate of figure 2, after the assembly of the main electronic substrate with the supporting frame,
Figure 4 shows the supporting frame and the main electronic substrate of figure 3, during a further step of assembly with a main cover of the electronic device of figure 1.

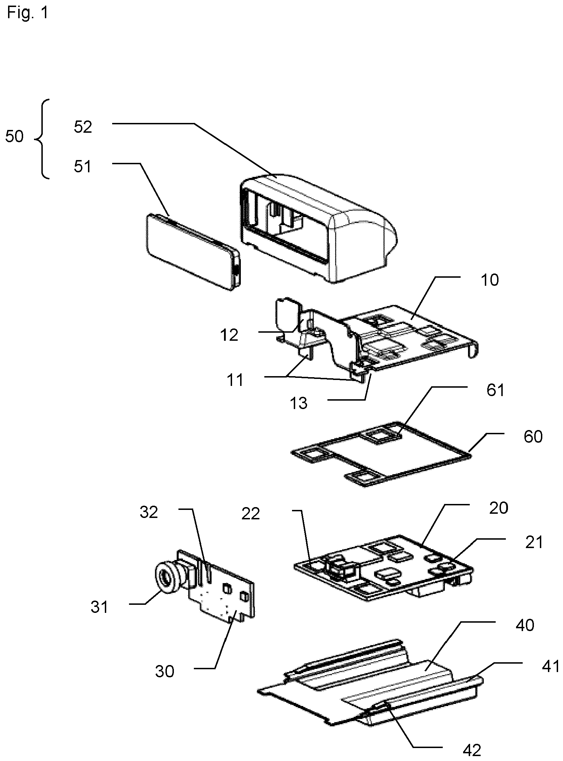

Figure 1 shows an exploded view of an electronic device (a camera, and in particular an infra-red camera), which is designed to be used in a vehicle.

The electronic device may include:
- a supporting frame 10;
- a main electronic substrate 20,
- a secondary electronic substrate 30,
- main cover 40,
- a secondary cover 50,
- a conductive paste strand 60.

In particular, it should be noted that the presence of the secondary electronic substrate 30 and/or secondary cover 50 and/or conductive paste strand 60 is(are) optional.

The supporting frame is typically a metallic part, and in the represented example, it is a metallic sheet punched, stamped and folded to present the complex three-dimensional shape shown on figure 1. In particular a main part of the supporting frame 10, on the right side, defines a first plane or first planar shape, and a second part of the supporting frame 10, on the left side, defines a second plane or second planar shape. In the given example, the first plane and the second plane are perpendicular.

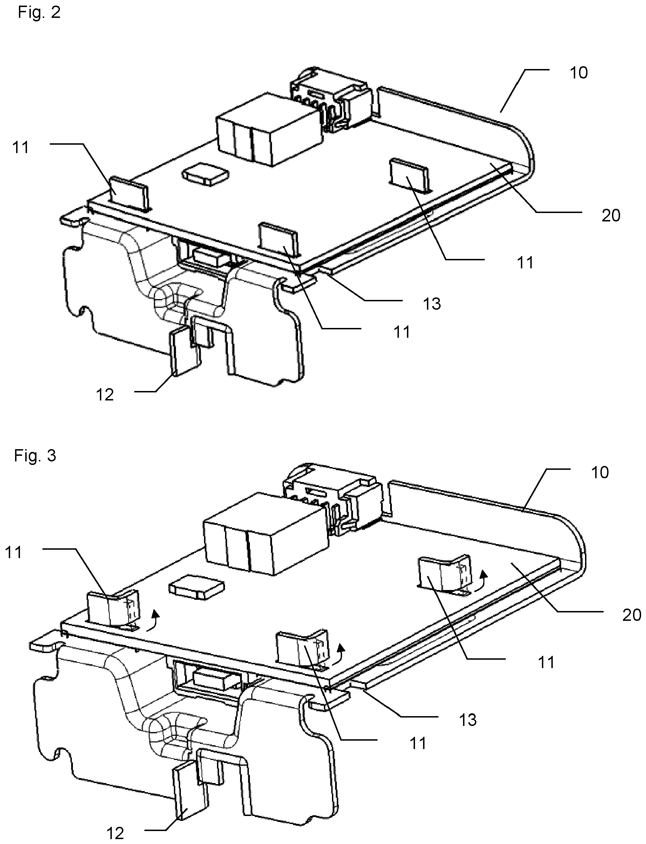

The supporting frame 10 has main projecting tabs 11 (shown figure 2 as well) projecting on a downward direction from the main part or first planar shape, and has secondary projecting tab 12 projecting to the left from the second part or second planar shape.

Typically, the main projecting tabs 11 and secondary projecting tab 12 are manufactured by punching and bending steps. The supporting frame has also locking openings 13 visible figure 1 and figure 2.

The main electronic substrate 20 is typically a printed circuit board, and hoists electric or electronic components 21, and/or electric or electronic circuits. The main electronic substrate 20 of figure 1 might include a rigid board made of resin, such as epoxy resin. Alternatively, the main electronic substrate 20 might mainly be made of a flexible film, made of polyimide material for example.

In the present example, the main electronic substrate 20 includes an electronic control unit (ECU), to drive and control the electronic device. However, other functions and components are possible.

As shown figure 1, the main electronic substrate 20 has trough holes 22 or slots, for receiving the main projecting tabs, as will be discusses hereunder.

The secondary electronic substrate 30 is typically a printed circuit board, and hoists electric or electronic components 31 (an electro-optic device in the present example), and/or electric or electronic circuits. The secondary electronic substrate 30 of figure 1 might include a rigid board made of resin, such as epoxy resin. Alternatively, the secondary electronic substrate 30 might mainly be made of a flexible film, made of polyimide material for example.

In the present example, the secondary electronic substrate 30 includes a lens and an optic sensor, to provide a camera capable of capturing pictures from the electronic device (thus forming a camera printed circuit board or PCB). In this embodiment, the camera is an infra-red camera. However, other functions and components are possible.

As shown figure 1, the main secondary substrate 30 has a slot 32, for receiving the secondary projecting tabs 12, as will be discusses hereunder.

The main cover 40 is provided in this example as a sheet of metal folded to include to lateral sliding portions 41 to be assembled to the supporting frame 10 via a sliding coupling operation. Flexible legs 42 are provide at the end of the lateral sliding portions.

The secondary cover 50 includes a screen 51 and a decorative cover 52. The screen 51 is made of a material transparent to infra-red rays, and the decorative cover might be made of plastics or any other material.

The conductive paste strand 60 is shown on figure 1 as an independent component, but it is rather deposited onto the supporting frame 10 in a liquid or pasty state, before assembly of the main electronic substrate 20, to achieve or provide electric contact or conductivity between these two components so as to ensure an adequate electric and/or magnetic field protection. Despite not shown, the conductive paste strand 60 is or can be also provided between the secondary electronic substrate 30 and the supporting frame 10.

One should notice that the conductive paste strand 60 includes closed loops 61 located in regards to the main projected tabs 11. In summary, when the electronic device is fully assembled, the conductive paste strand 60 is sandwiched or in contact with the supporting frame 10 and the main electronic substrate 20. Typically, the conductive paste strand is a foam, or a resin or a grease or a polymeric component which has electric conductive capacity, or which is loaded with electric conductive particles.

Figure 2 represents a step of the assembly of the main electronic substrate 20 onto the supporting frame 10. In detail, the main electronic substrate 20 has been positioned onto the supporting frame 10 so that the main projected tabs 11 pass through the through holes 22 of the main electronic substrate 20. Typically, the conductive paste strand 60, not visible on this figure 2, has already been deposited onto the supporting frame 10 or onto the main electronic substrate 20.

As shown figure 3 by the arrows, the next step is to secure/attach the main electronic substrate 20 onto the supporting frame 10 by bending or twisting the main projected tabs 11. This is providing an easy and nonreversible way to attach the components together, as no screws are required. In other words, the projecting tabs 11, all shown in an initial and not bent position on figure 2 are all bent and twisted to occupy a final bent position, the one shown figure 3.

One should note that the closed loops 61 of the conductive paste strand 60 are at least partially in close vicinity of the main projected tabs 11 in the final bent position, ensuring good and reliable contact between the supporting frame 10, main electronic substrate 20 and conductive paste strand 60. In particular, at least one portion of the closed loops 61 is in regards of the bent main projecting tabs 11.

Similar assembly is provided with the secondary electronic substrate 30: it is positioned onto the supporting frame 10, the secondary projecting tab 12 passing through the slot 32, so that further bending or twisting of the secondary projecting tab 12 secure the attachment of these two components.

In summary, the bending of the main and secondary projecting tabs 11 and 12 is sufficient to achieve a reliable and full attachment of the electronic substrates to the supporting frame 10. No tooling (screwing, riveting... tools) are required for the operator, so that the assembly sequence is simplified.

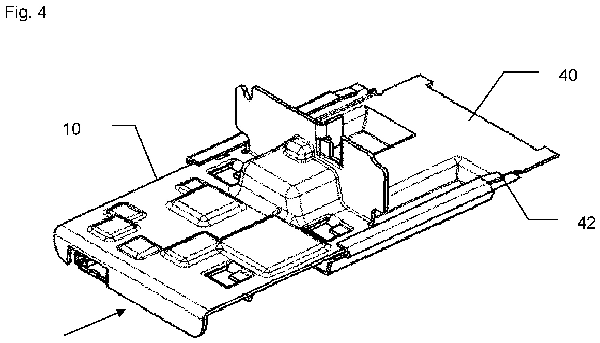

Figure 4 represents the step of assembly of the supporting frame 10 to the main cover 40. The supporting frame 10 (coupled to the main electronic substrate 20, not visible on figure 4) is shown up-side down and from rear direction compared to figure 2, and inserted into the lateral sliding portions 41 so that the supporting frame 10 is "sled into" the main cover 40 to cover the main electronic substrate 20.

The supporting frame can be pushed as shown by the arrow on figure 4, until it arrives in abutment with the main cover 40, where the flexible legs 42 can engage into the locking openings 13 of the supporting frame 10, to lock the latter in the final position of assembly.

At this stage of assembly, the main projecting tabs 11 are twisted in the final and bent position. Therefore, it is possible to slide the supporting frame 10 into the final assembled position. Otherwise, if one of the projecting tabs 11 is not fully bent into the final and bent position, it would interfere or abut with the main cover 40, so that assembly of the supporting frame 10 and main cover 40 is impossible. This specific arrangement provides additional check or insurance that only a main electronic substrate 20 fully and securely assembled to the supporting frame 10 is further assembled to the main cover 40. The main projecting tabs in the initial and non-bent position act as poka yoke and render assembly of supporting frame 10 and main cover 40 impossible.

It has to be noted that same situation can be implemented for the assembly of the secondary cover 50. The secondary projecting tab 12 can be sized so that in the initial and non-bent position, any assembly of the supporting frame 10 to the secondary cover 50 is impossible, due to an interference. In the final and bent position, the secondary projecting tab 12 does not prevent or block the assembly of the supporting frame 10 to the secondary cover 50.

In summary, the projecting tabs (main or secondary) provide notably the capacity to simplify the assembly operations of the components to the supporting frame and prevent further assembly if they are not properly twisted or bent.

One should note that projecting tabs of the supporting frame could be used to attach other components than electronic substrates.

## Claims

1. Electronic device such as a camera for a vehicle, including:
- a supporting frame (10),
- a main electronic substrate (20), provided with at least one electric or electronic component (21) or circuit and coupled to the supporting frame (10);
- wherein the supporting frame (10) has at least one main projecting tab (11), capable to occupy a non-twisted position or a twisted position,
wherein the main projecting tab (11), when in the twisted position, is providing an attachment of the main electronic substrate (20) to the supporting frame (10),
the electronic device including a main cover part (40), and wherein said at least one of the main projecting tab (11):
- when in the non-twisted position, is interfering with the main cover part (40), so as to prevent an assembly operation of the main cover part (40) to the electronic device ;
- when in the twisted position, is not interfering with the main cover part (40), so as to allow an assembly operation of the main cover part (40) to the electronic device.

2. Electronic device according to claim 1,
wherein the main cover part (40) is coupled to the supporting frame (10), preferably in a sliding arrangement.

3. Electronic device according to claim 2,
including at least one elastic leg (42), wherein the main cover part (40) is locked to the supporting frame (10) in a final assembled position by the elastic leg (42).

4. Electronic device according to any one of claims 1 to 3, including:
- a secondary electronic substrate (30), provided with at least one electric or electronic component (31) or circuit and coupled to the supporting frame (10);
- wherein the supporting frame (10) has at least one secondary projecting tab (12), capable to occupy a non-twisted position or a twisted position,
wherein the secondary projecting tab (12), when in the twisted position, is providing an attachment of the secondary electronic substrate (30) to the supporting frame (10).

5. Electronic device according to claim 4,
wherein the main electronic substrate (20) is defining a first plane;
wherein the secondary electronic substrate (30) is defining a second plane;
and wherein the second plane is distinct from the first plane, preferably the second plane and the first plane are intersecting planes, and preferably the second plane and the first plane are perpendicular planes.

6. Electronic device according to any one of claims 4 to 5, including a secondary cover part (50),
and wherein at least one of the main projecting tab (11) and the secondary projecting tab (12):
- when in the non-twisted position, is interfering with the secondary cover part (50), so as to prevent an assembly operation of the secondary cover part (50) to the electronic device ;
- when in the twisted position, is not interfering with the secondary cover part (50), so as to allow an assembly operation of the secondary cover part (50) to the electronic device.
or wherein said at least one of the secondary projecting tab (12):
- when in the non-twisted position, is interfering with the main cover part (40), so as to prevent an assembly operation of the main cover part (40) to the electronic device ;
- when in the twisted position, is not interfering with the main cover part (40), so as to allow an assembly operation of the main cover part (40) to the electronic device.

7. Electronic device according to claim 6, wherein the secondary cover part (50) includes a decorative cover part (52), and a window (51) preferably made of an infra-red transparent material.

8. Electronic device according to any one of claims 1 to 7, including a conductive paste strand (60) at least in contact with the main electronic substrate (20) and/or the secondary electronic substrate (30).

9. Electronic device according to claim 8,
wherein the main electronic substrate (20) has a main through hole (22) and/or the secondary electronic substrate (30) has a secondary through hole (32),
wherein the main projecting tab (11) is passing through the main through hole (22) and/or the secondary projecting tab (12) is passing through the secondary through hole (32),
and wherein the conductive paste strand (60) has a portion surrounding the main through hole (22) and/or the secondary through hole (32).

10. Electronic device according to claim 8 or 9,
wherein the main projecting tab (11) or the secondary projecting tab (12) presents a twisted length over the main electronic substrate (20),
wherein the conductive paste strand (60) has a portion located from the main through hole and/or the secondary through hole at a distance less than the twisted length.

11. Electronic device according to any one of claims 8 to 10,
wherein the conductive paste strand (60) has a portion located from the main through hole and/or the secondary through hole by less than 20 mm.

12. Electronic device according to any one of claims 8 to 11,
wherein the conductive paste strand (60) has a portion surrounding the main electronic substrate (20) and/or the secondary electronic substrate (30).

13. Electronic device according to any one of claims 1 to 12,
wherein:
the attachment of the main electronic substrate (20) to the supporting frame (10) is solely or exclusively provided by the main projecting tab (11) in the twisted position,
the attachment of the secondary electronic substrate (30) to the supporting frame (10) is solely or exclusively provided by the secondary projecting tab (12) in the twisted position.

14. Vehicle, including an electronic device according to any one of the claims 1 to 13.

## Patentansprüche

1. Elektronisches Gerät, wie eine Kamera für ein Fahrzeug, umfassend:
- Halterahmen (10),
- elektronisches Hauptsubstrat (20), das mit mindestens einer elektrischen oder elektronischen Komponente (21) oder einem Schaltkreis ausgestattet ist und mit dem Halterahmen (10) gekoppelt ist;
- wobei der Halterahmen (10) mindestens eine primäre vorstehende Rastnase (11) hat, die in der Lage ist, eine nicht gebogene oder eine gebogene Position einzunehmen,
wobei die primäre vorstehende Rastnase (11), wenn sie sich in der gebogenen Position befindet, eine Befestigung des elektronischen Hauptsubstrats (20) an dem Halterahmen (10) bietet,
das elektronische Gerät umfasst einen primären Abdeckteil (40), wobei die mindestens eine der primären vorstehenden Rastnasen (11):
- wenn sie sich in der nicht gebogenen Position befindet, in das primäre Abdeckteil (40) eingreift, um so einen Zusammenfügevorgang des primären Abdeckteils (40) mit dem elektronischen Gerät zu verhindern;
- wenn sie sich in der gebogenen Position befindet, nicht in das primäre Abdeckteil (40) eingreift, um so einen Zusammenfügevorgang des primären Abdeckteils (40) mit dem elektronischen Gerät zu erlauben.

2. Elektronisches Gerät nach Anspruch 1,
wobei das primäre Abdeckteil (40) mit dem Halterahmen (10) gekoppelt ist, vorzugsweise in einer Schiebeanordnung.

3. Elektronisches Gerät nach Anspruch 2,
umfassend mindestens einen elastischen Abschnitt (42), wobei der primäre Abdeckteil (40) an dem Halterahmen (10) in einer endgültigen Zusammenfügeposition durch den elastischen Abschnitt (42) verriegelt wird.

4. Elektronisches Gerät nach einem der Ansprüche 1 bis 3, umfassend:
- Sekundäres elektronisches Substrat (30), das mit mindestens einer elektrischen oder elektronischen Komponente (31) oder einem Schaltkreis ausgestattet ist und mit dem Halterahmen (10) gekoppelt ist;
- wobei der Halterahmen (10) mindestens eine sekundäre vorstehende Rastnase (12) hat, die in der Lage ist, eine nicht gebogene Position oder eine gebogene Position einzunehmen, wobei die sekundäre vorstehende Rastnase (12), wenn sie sich in der gebogenen Position befindet, eine Befestigung des sekundären elektronischen Substrats (30) mit dem Halterahmen (10) bietet.

5. Elektronisches Gerät nach Anspruch 4,
wobei das primäre elektronische Substrat (20) eine erste Ebene definiert; wobei das sekundäre elektronische Substrat (30) eine zweite Ebene definiert; und wobei sich die zweite Ebene von der ersten Ebene unterscheidet, vorzugsweise sind die zweite Ebene und die erste Ebene sich schneidende Ebenen, und vorzugsweise sind die zweite Ebene und die erste Ebene senkrecht zueinander stehende Ebenen.

6. Elektronisches Gerät nach einem der Ansprüche 4 bis 5, umfassend einen sekundären Abdeckteil (50),
und wobei mindestens entweder die primäre vorstehende Rastnase (11) oder die sekundäre vorstehende Rastnase (12):
- wenn sie sich in der nicht gebogenen Position befindet, in das sekundäre Abdeckteil (50) eingreift, um so einen Zusammenfügevorgang des sekundären Abdeckteils (50) mit dem elektronischen Gerät zu verhindern;
- wenn sie sich in der gebogenen Position befindet, nicht in das sekundäre Abdeckteil (50) eingreift, um so einen Zusammenfügevorgang des sekundären Abdeckteils (50) mit dem elektronischen Gerät zu erlauben.
oder wobei die mindestens eine sekundäre vorstehende Rastnase (12):
- wenn sie sich in der nicht gebogenen Position befindet, in das primäre Abdeckteil (40) eingreift, um so einen Zusammenfügevorgang des primären Abdeckteils (40) mit dem elektronischen Gerät zu verhindern;
- wenn sie sich in der gebogenen Position befindet, nicht in das primäre Abdeckteil (40) eingreift, um so einen Zusammenfügevorgang des primären Abdeckteils (40) mit dem elektronischen Gerät zu erlauben.

7. Elektronisches Gerät nach Anspruch 6, wobei der sekundäre Abdeckteil (50) einen Dekor-Abdeckteil (52) umfasst, und ein Fenster (51), das vorzugsweise aus einem infrarottransparenten Material hergestellt ist.

8. Elektronisches Gerät nach einem der Ansprüche 1 bis 7, umfassend, einen Leitpasten-Strang (60), der mindestens in Kontakt mit dem primären elektronischen Substrat (20) und/oder dem sekundären elektronischen Substrat (30) steht.

9. Elektronisches Gerät nach Anspruch 8,
wobei das primäre elektronische Substrat (20) eine primäre Durchgangsbohrung (22) und/oder das sekundäre elektronische Substrat (30) eine sekundäre Durchgangsbohrung (32) hat,
wobei die primäre vorstehende Rastnase (11) durch die primäre Durchgangsbohrung (22) und/oder die sekundäre vorstehende Rastnase (12) durch die sekundäre Durchgangsbohrung (32) verläuft,
und wobei der Leitpasten-Strang (60) einen Abschnitt hat, der die primäre Durchgangsbohrung (22) und/oder die sekundäre Durchgangsbohrung (32) umgibt.

10. Elektronisches Gerät nach Anspruch 8 oder 9,
wobei die primäre vorstehende Rastnase (11) oder die sekundäre vorstehende Rastnase (12) eine gebogene Länge über dem primären elektronischen Substrat (20) aufweist, wobei der Leitpasten-Strang (60) einen Abschnitt hat, der von der primären Durchgangsbohrung und/oder der sekundären Durchgangsbohrung in einem Abstand platziert ist, der geringer ist als die gebogene Länge.

11. Elektronisches Gerät nach einem der Ansprüche 8 bis 10,
wobei der Leitpasten-Strang (60) einen Abschnitt hat, der von der primären Durchgangsbohrung und/oder der sekundären Durchgangsbohrung weniger als 20 mm entfernt ist.

12. Elektronisches Gerät nach einem der Ansprüche 8 bis 11,
wobei der Leitpasten-Strang (60) einen Abschnitt hat, der das primäre elektronische Substrat (20) und/oder das sekundäre elektronische Substrat (30) umgibt.

13. Elektronisches Gerät nach einem der Ansprüche 1 bis 12, wobei:
Die Befestigung des primären elektronischen Substrats (20) an dem Halterahmen (10) nur oder ausschließlich an der primären vorstehenden Rastnase (11) in der gebogenen Position vorhanden ist,
die Befestigung des sekundären elektronischen Substrats (30) an dem Halterahmen (10) nur oder ausschließlich an der sekundären vorstehenden Rastnase (12) in der gebogenen Position vorhanden ist.

14. Fahrzeug, umfassend ein elektronisches Gerät nach einem der Ansprüche 1 bis 13.

## Revendications

1. Dispositif électronique tel qu'une caméra destinée à un véhicule, comportant :
- un cadre de support (10),
- un substrat électronique principal (20), doté d'au moins un composant ou circuit électrique ou électronique (21) ou circuit et accouplé au cadre de support (10) ;
- dans lequel le cadre de support (10) présente au moins une languette saillante principale (11), pouvant occuper une position non torsadée ou une position torsadée,
dans lequel la languette saillante principale (11), lorsqu'elle est en position torsadée, assure une fixation du substrat électronique principal (20) au cadre de support (10),
le dispositif électronique comportant une pièce de couvercle principale (40), et dans lequel ladite au moins une des languettes saillantes principales (11) :
- lorsqu'elle est en position non torsadée, interfère avec la pièce de couvercle principale (40), de manière à empêcher la mise en oeuvre de l'assemblage de la pièce de couvercle principale (40) avec le dispositif électronique ;
- lorsqu'elle est en position torsadée, n'interfère pas avec la pièce de couvercle principale (40), de manière à permettre la mise en oeuvre de l'assemblage de la pièce de couvercle principale (40) avec le dispositif électronique.

2. Dispositif électronique selon la revendication 1,
dans lequel la pièce de couvercle principale (40) est accouplée au cadre de support (10), de préférence dans un agencement coulissant.

3. Dispositif électronique selon la revendication 2,
comportant au moins une jambe élastique (42), dans lequel la pièce de couvercle principale (40) est verrouillée au cadre de support (10) dans une position assemblée finale par la jambe élastique (42).

4. Dispositif électronique selon l'une quelconque des revendications 1 à 3 comportant :
- un substrat électronique secondaire (30), doté d'au moins un composant ou circuit électrique ou électronique (31) ou circuit et accouplé au cadre de support (10) ;
- dans lequel le cadre de support (10) présente au moins une languette saillante secondaire (12), apte à occuper une position non torsadée ou une position torsadée, dans lequel la languette saillante secondaire (12), lorsqu'elle est en position torsadée, assure une fixation du substrat électronique secondaire (30) au cadre de support (10).

5. Dispositif électronique selon la revendication 4,
dans lequel le substrat électronique principal (20) définit un premier plan ;
dans lequel le substrat électronique secondaire (30) définit un second plan ; et dans lequel le second plan est distinct du premier plan, de préférence le second plan et le premier plan sont des plans qui se croisent et de préférence le second plan et le premier plan sont des plans perpendiculaires.

6. Dispositif électronique selon l'une quelconque des revendications 4 à 5 comportant une pièce de couvercle secondaire (50),
et dans lequel au moins une parmi la languette saillante principale (11) et la languette saillante secondaire (12) :
- lorsqu'elle est en position non torsadée, interfère avec la pièce de couvercle secondaire (50), de manière à empêcher la mise en oeuvre de l'assemblage de la pièce de couvercle secondaire (50) avec le dispositif électronique ;
- lorsqu'elle est en position torsadée, n'interfère pas avec la pièce de couvercle secondaire (50), de manière à permettre la mise en oeuvre de l'assemblage de la pièce de couvercle secondaire (50) avec le dispositif électronique.
ou dans lequel ladite au moins une des languettes saillantes secondaires (12) :
- lorsqu'elle est en position non torsadée, interfère avec la pièce de couvercle principale (40), de manière à empêcher la mise en oeuvre de l'assemblage de la pièce de couvercle principale (40) avec le dispositif électronique ;
- lorsqu'elle est en position torsadée, n'interfère pas avec la pièce de couvercle principale (40), de manière à permettre la mise en oeuvre de l'assemblage de la pièce de couvercle principale (40) avec le dispositif électronique.

7. Dispositif électronique selon la revendication 6, dans lequel la pièce de couvercle secondaire (50) comprend une pièce de couvercle décorative (52) et une fenêtre (51) constituées de préférence d'un matériau transparent aux infrarouges.

8. Dispositif électronique selon l'une quelconque des revendications 1 à 7, comportant un fil de pâte conductrice (60) au moins en contact avec le substrat électronique principal (20) et/ou le substrat électronique secondaire (30).

9. Dispositif électronique selon la revendication 8,
dans lequel le substrat électronique principal (20) comporte un trou traversant principal (22) et/ou le substrat électronique secondaire (30) présente un trou traversant secondaire (32),
dans lequel la languette saillante principale (11) passe par le trou traversant principal (22) et/ou la languette saillante secondaire (12) passe par le trou traversant secondaire (32),
et dans lequel le fil de pâte conductrice (60) présente une partie entourant le trou traversant principal (22) et/ou le trou traversant secondaire (32).

10. Dispositif électronique selon la revendication 8 ou 9,
dans lequel la languette saillante principale (11) ou la languette saillante secondaire (12) présente une longueur torsadée sur le substrat électronique principal (20),
dans lequel le fil de pâte conductrice (60) présente une partie située à partir du trou traversant principal et/ou du trou traversant secondaire à une distance inférieure à la longueur torsadée.

11. Dispositif électronique selon l'une quelconque des revendications 8 à 10,
et dans lequel le fil de pâte conductrice (60) présente une partie située à partir du trou traversant principal et/ou du trou traversant secondaire par moins de 20 mm.

12. Dispositif électronique selon l'une quelconque des revendications 8 à 11,
dans lequel le fil de pâte conductrice (60) présente une partie entourant le substrat électronique principal (20) et/ou le substrat électronique secondaire (30).

13. Dispositif électronique selon l'une quelconque des revendications 1 à 12,
dans lequel :
la fixation du substrat électronique principal (20) au cadre de support (10) est assurée uniquement ou exclusivement par la languette saillante principale (11) en position torsadée,
la fixation du substrat électronique secondaire (30) au cadre de support (10) est assurée uniquement ou exclusivement par la languette saillante secondaire (12) en position torsadée.

14. Véhicule, comportant un dispositif électronique selon l'une quelconque des revendications 1 à 13.
